# EUROPEAN PATENT APPLICATION

(11) **EP 1 047 135 A2**
(43) Date of publication of application: **25.10.2000**
(21) Application number: 00401111.0
(22) Date of filing: 20.04.2000
(51) Int. Cl.: H01L 29/86, H01L 29/739, H01L 29/16

(54) **Fast turn-off power semiconductor devices**

(30) Priority: 22.04.1999 US 296472
(71) Applicant: Intersil Corporation, Palm Bay, Florida 32905 (US)
(72) Inventor: Hao, Jifa, White Haven, PA 18661 (US)
(74) Representative: Ballot, Paul

(57) **Abstract**

A semiconductor switch is provided with fast turn-off characteristics by the mechanism of rapid recombination of minority carriers within a charge injecting region of the device. The region itself, or a portion of each of a plurality of parallelconnected such regions, comprises a body of highly doped polycrystalline silicon comprising tiny mono-crystalline grains of silicon joined at boundaries between the grains. The grain boundaries provide deep level energy traps for the capture and rapid annihilation, by recombination, of minority carriers within the polycrystalline body. An electrode is ohmically contacted with the one or each polycrystalline silicon body for efficient injection of majority carriers into the body.

## Description

This invention relates to electrical power controlling semiconductor devices in general, and in particular to semiconductor power switches having a combination of desired characteristics including fast turn-off speed.

Power semiconductor devices are used for controlling the flow of electrical power to various electrical loads, e.g., electric motors. Desired characteristics of such devices are that they have low electrical losses, e.g., low forward voltage drop and low power consumption, and that they can be quickly switched off for rapidly turning power off at the load.

Electronics for applying turn-off signals to electrical circuits can be extremely fast. However, even when electrical turn-off signals are applied to the power switching devices, the devices are not fully off, for fully turning power off at the electrical load, until all minority charge carriers within the switching device are removed. That is, even in the absence of external applied voltages, such charge carriers provide a continuing, although decaying, power flow through the system.

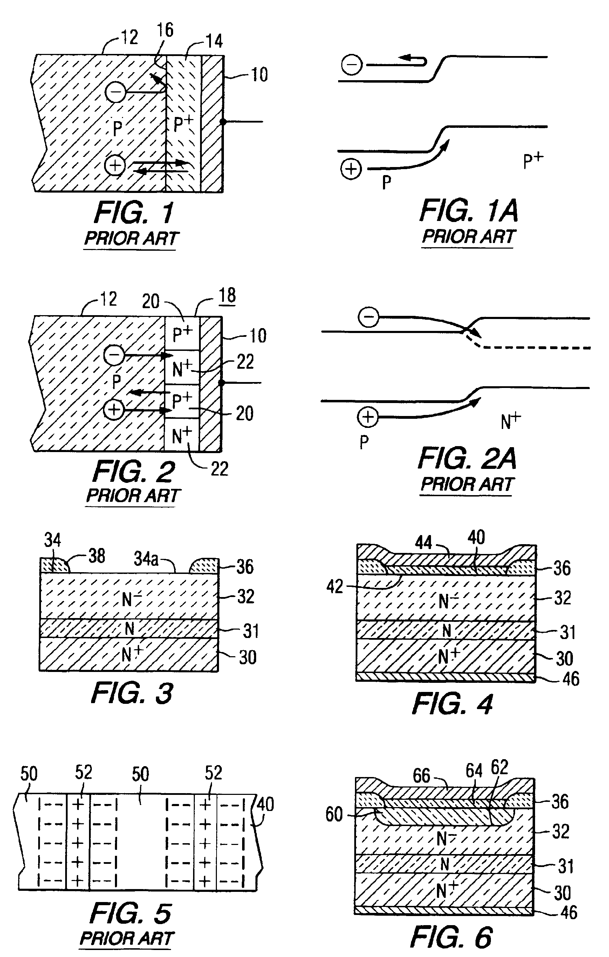

One aspect of the problem of obtaining rapid turn-off of power semiconductor switches is disclosed in a paper by Amemiya et al, "Novel Low-Loss and High Speed Diode Utilizing an 'Ideal' Ohmic Contact", IEEE Transactions on Electron Devices, Vol. ED-29, No. 2, Feb., 1982, Which explains that in bipolar switching devices where minority carrier flow is important, a problem is that of removing minority carriers at the device main terminals where majority carriers are normally injected. For example, at the main terminal 10, as shown in Fig. 1 herein (copied from the paper), connected to a lightly doped p⁻ region 12, conventional practice is to provide a highly doped p⁺ region 14 at the surface 16 of the region 12 for obtaining a good "ohmic" (non-rectifying) contact between the terminal 10 and the p- region 12. A problem, however, is that the p⁺p junction 16 between the two regions 12 and 14 acts as an electrical barrier to the flow of minority carriers (electrons) within the source region 12 into the region 15 and thence to the terminal 10. This electrical barrier is indicated in the band structure diagram shown in Fig. 1A where the steps in the energy potentials at the p⁺ p junction 16 function as a retarding barrier to electrons (-) but as a attracting well for holes (+). As described in the paper, the electrons are "stagnated ans accumulated in the p region" (12) and, owing to the difficulty of removing the minority carriers at turn-off, reduced turn-off speeds result. The solution described in the paper, shown in Fig. 2, is the replacement of the p⁺ region 14 with a p⁺n⁺ mosaic layer 18, i.e., a thin layer consisting of a plurality of alternating p⁺ (20) and n⁺ (22) regions. Both regions provide good ohmic contact to the terminal; the p⁺ regions 20 (similar to the p⁺ region 14 in Fig. 1) providing efficient injection and collection ( at device turn-off) of the majority carriers, and the n⁺ regions 22, as indicated in Fig. 2A, providing efficient collection of minority carriers.

The paper discloses that the necessary boundary condition for an ideal ohmic contact is an indefinite recombination velocity so that carrier density at contact boundary is always maintained at the thermodynamic equilibrium values of the semiconductor. With the solution provided in the paper, the minority-carrier recombination velocity is "equivalently infinite" at the contact boundary, and the problem of minority carrier accumulation is thus avoided. The present invention also relies on high recombination rate for avoiding minority carrier accumulation but, uses a different structure and a different physical mechanism.

Other known techniques, relevant to the present invention (involving high recombination rates), are recombination traps, e.g., metal impurities such as gold or platinum, within the semiconductor body provide localized regions where high recombination velocities are obtained. At such traps, otherwise mobile charge carriers of opposite type are captured and recombined, i.e., annihilated. Thus, during device turn-off, minority carriers within the device, otherwise requiring long duration paths for removal, are far more rapidly removed by localized trapping and annihilation.

A related technique is to cause lattice damage, in the form of vacancies and interstitial atoms, in the monocrystalline semiconductor material by high energy particles, e.g., E-beam and nucleon beam irradiation. The lattice defects function, similarly as the metal impurity diffused traps, as charge carrier traps.

A problem with the aforementioned trapping techniques, involving metal impurity diffusion and lattice damage by high energy particles, is that the resulting traps are distributed throughout the entire body of semiconductor material rather than where specifically wanted, e.g., inn the p region 12 of the devices shown in Figs. 1 and 2. Where unwanted and unneeded, the traps tend to increase device resistivity and device electrical losses. Also, the trap introducing process tends to be expensive.

The present invention includes a fast turn-off semiconductor power controlling switch comprising a first region of monocrystalline silicon forming a p-n junction with a second region of silicon including a third region of highly doped polycrystalline silicon, said third region having a surface spaced from but directly overlying said p-n junction and electrode directly overlying and ohmically connected to said surface of said third region for injection charge carriers therein and thence into said second and said first regions.

A semiconductor power switching device comprises a body of monocrystalline silicon having a first region of a first conductivity type at a first surface of the body. A layer of doped polycrystalline silicon ("polysilicon") is provided on the surface in direct contact with the first region.

In one embodiment, the polysilicon layer is highly doped to a second conductivity type and forms a p-n junction with the first region; the polysilicon layer thus functioning as a charge injector in the switching device and a means for controlling the lifetime of minority carriers within devices.

In a second embodiment, the highly doped polysilicon layer is of the same conductivity type as the first region and provides, in effect, an extension of the first region. The polysilicon layer does not itself form a p-n junction. Rather, the first region forms a p-n junction with an underlying second region, and the combination of polysilicon layer and the first region functions as a charge indicator in the switching device.

In both embodiments, the polysilicon layer is contacted by an overlying metal terminal in ohmic contact with the polycrystalline layer.

In one or both embodiments, the polysilicon layer is but one of numerous such layers spaced apart along the first surface of the silicon body and connected, e.g., in parallel, by a common metal terminal. In another embodiment, the polysilicon layer is a single layer along one surface of the body underlying and common to a plurality of parallel-connected, spaced apart, doped regions disposed along an opposite surface of the body.

As known, "polysilicon" (i.e., polycrystalline silicon) comprises an aggregate of monocrystalline grains of silicon adhered to one another at grain boundaries. The monocrystalline grains function as "normal" monocrystalline silicon and, in the first embodiment, comprise "normal" tiny charge injector regions connected in parallel. In the second embodiment, the monocrystalline grains comprise highly doped regions providing ohmic contacts between the first region and the metal terminal. The boundaries between the grains, however, serve as lattice defects providing regions of high recombination for trapping of minority carriers for preventing unwanted accumulation of the minority carriers and fast turn-off speeds. The recombination regions, however, are disposed only where needed, and while the desired fast switching speed is achieved, no adverse effects on device conductivity and electrical performance are created.

The present invention will now be described, by way of example with reference to the accompanying drawings in which the drawings are schematic, and Figs. 1-4, 6 and 9 are partial side sections of semiconductor chips of various semiconductor devices, in which:
FIGURES 1 and 2 are copied from Figs. 1 and 2 of the prior cited paper by Amemiya et al illustrating a prior art problem and a prior art solution to the problem;
FIGURES 1A and 2A are band structure diagrams based upon similar diagrams in the Amemiya et al paper corresponding to the devices shown in Figs. 1 and 2 herein, respectively;
FIGURE 3 shows a stage in the fabrication of a device according to the present invention; the stage illustrated being where a modification of a prior art device is thereafter made in accordance with this invention;
FIGURES 4, 6 and 9 show three embodiments of devices made according to invention;
FIGURE 5 is a known symbolic depiction of the grain structure of a layer of polycrystalline silicon ( also referred to as "polysilicon");
FIGURE 7 is an energy band diagram for p doped polysilicon; and
FIGURE 8 is a bond structure diagram similar to Figs. 1A and 2A but for a polysilicon grain boundary region.

The present invention involves the use of a body, e.g., a layer, of doped polycrystalline silicon ("polysilicon") forming an ohmic contact interface between a body of silicone and a metal electrode. Layers of doped polysilicon are used as gate electrodes overlying and contacting a layer of dielectric material. Such gate electrodes do not form an ohmic contact with monocrystalline silicon body. In somewhat rare devices, however, are used as signal amplifiers, rather than as power switches, and switching speeds are not relevant.

A first embodiment of the invention is now described in connection with Fig. 3. Fig. 3 is schematic and shows a portion of a known semiconductor device workpiece where the portion shown comprises essentially the entire electrically active portion of the completed device, e.g., a diode rectifier, or only one of a plurality of identical spaced apart portions connected in parallel of, e.g., as insulted gate bipolar transistor (IGBT). The workpiece portion comprises (as in known devices) a layer 30 of silicon highly doped, in this example, with n type dopant (arsenic or antimony) atoms. Overlying the layer 30 is a layer 31 moderately (n) doped overlaid, in turn, by a layer 32 of silicon lightly (n⁻) doped. In some devices, the layer 31 is a known "buffer" layer. All layers 30, 31, and 32 are essentially part of a single crystal of silicon wherein, and dependent upon the particular device being made, one or more layers of doped silicon are epitaxially grown on a monocrystalline substrate and doped regions are optionally formed by introduction of dopant atoms, e.g., by ion implantation. Overlying the surface 34 of the layer 32 is a dielectric layer 36, thermally grown silicon dioxide, which has been photo lithographically patterned to provide an opening 38 through the layer 36 exposing a portion 34a of the surface of layer 32.

The workpiece shown in Fig. 3 can be identical with a prior art workpiece fabricated using known processing techniques. Typically, with such prior art workpiece, p type dopant atoms are then introduced into the layer 32, e.g., by ion implantation, to form a p type charge injecting region overlaid (as in Fig. 1) with a p⁺ layer for good ohmic contact to a later applied electrode. Conversely, in the present embodiment (but not in a second embodiment to be described), a layer 40 (Fig. 4) of highly doped polysilicon (p type in this example) is deposited on the workpiece. Preferably, quite high doping concentrations are used, e.g., in excess of 10²⁰ atoms/cm³.

The deposition of polysilicon layer is well known. After deposition of the polysilicon, known processes, e.g., chemical etchings or RIE (reactive ion etching), are used selectively to remove the polysilicon material over the oxide layer 36. The result of the polysilicon deposition and selective removal processes is shown in Fig. 4. The polysilicon layer 40 comprises, as known, bonded together, tiny grains of monocrystalline silicon.

The p doped polysilicon layer 40 forms a p-n junction 42 with the underlying n layer 32. To complete the device (i.e., that portion of a device being illustrated), a layer 44 of metal, e.g., aluminum, titanium, nickel and silver, is deposited (and patterned) by known processes to provide a terminal connection to polysilicon layer 40.

In the completed device shown in Fig. 4 (other, not illustrated portions of the device corresponding identically to prior art devices), the polysilicon layer 40 comprises, in the illustrative device, a charge injector region forming a p-n junction 42 with an n⁻ region 32 of a device corresponding to (for example) a known PIN diode (where, as in typical diodes, the I stands for "intrinsic" but is actually a lightly doped region of either n or p type conductivity). In use of such PIN diodes, the device is in low forward voltage, highly conductive ON operation with a positive voltage on th p doped polysilicon layer 40 and a negative voltage on (in such PIN diode) n⁺ layer 30 (via a metal terminal 46). The device is in its reverse biased OFF condition when the polarities of the applied voltages are reversed, i.e., a negative voltage applied to the p polysilicon layer 40 and a positive voltage applied to the n⁺ layer 30.

Switching of the device back and forth between ON and OFF states can be exactly as with prior known PIN diodes but with generally better turn-off performance.

In connection with the aforecited Amemiya paper, turn-off of such known PIN diodes is slowed by the accumulation of minority carriers within the lightly doped region 12 (Fig. 1) of the device by the presence of a heavily doped region 14 providing an ohmic contact with a metal terminal 10. The solution described in the paper is the use of a mosaic p⁺-n⁺ contact region 18 (Fig. 2) providing a good ohmic path for the minority carriers. For a number of reasons, including fabrication difficulties, such mosaic contact regions have not come into extensive commercial use.

Substantially the same improvement in switching speed achieved by the mosaic contact region of the Amemiya paper is achieved but using a different mechanism, i.e., charge carrier trapping versus the improved ohmic path of the mosaic contact.

Fig. 5 is a schematic microscopic view of a section of the polysilicon layer 40 shown in Fig. 4. The layer 40 is made up of tiny grains 50 of highly doped monocrystalline silicon bound to one another at grain boundaries 52. In comparison with mosaic contact, functions as a good ohmic path for majority charge carriers, i.e., holes through the p doped silicon grains.

Compared to mosaic contact 18, no comparable good ohmic path exists for minority carriers through the p⁺ grains. Rather than conducting minority carriers to the metal terminal 44 (Fig. 4), the boundaries 52 between the grains serve as deep traps (indicated by + sign) in the silicon energy gap where minority charge carriers are trapped and annihilated by combination with trapped majority carriers. Provided a sufficient concentration of traps is available, the lifetime of the minority carriers is so substantially reduced that the minority carriers within the polysilicon layer 40 very rapidly disappear at device turn-off leading to a very rapid turn-off switching speed.

In the embodiment of the invention shown in Fig. 4, the layer 40 of p doped polysilicon forms, as described, a p-n junction 42 with the adjoining n⁻ layer 32 and the polysilicon layer 40 functions as a charge injector, e.g., p emitter, of the device. A problem, however, with a p-n junction formed between polysilicon and silicon is that the traps in the polysilicon give rise to a relatively large junction reverse leakage current. In order to reduce such leakage current, a further embodiment is described.

Fig. 6 shown a modification of the device shown in Fig. 4. For the purposes of comparison with the Fig. 4 device, the Fig. 6 device is also a PIN diode, but the p emitter region 60 comprises a conventional doped region formed, e.g., by diffusion of boron into a upper portion of the epi-layer. The p region 60 forms a p-n junction 62 with the n⁻ layer 32. Because the regions 60 and 32 are both of monocrystalline silicon, low reverse leakage currents are present With simply a conductive metal electrode, e.g., of aluminum or the like, contacting the p region 60 (through an intervening p⁺ layer for good ohmic contact, as in Fig. 1), the device would comprise a prior art PIN diode not having improved turn-off switching speed.

However, a p type, heavily doped polysilicon layer 64 is provided in contact with the p region 60, and a additional metal layer 66 is provided directly overlying and contacting the polysilicon layer 64. The processes described for providing the polysilicon layer 64 and the metal layer 66 can be identical to those used for providing the polysilicon 40 and metal layers 44 in the device shown in Fig. 4.

In the Fig. 6 device, the highly doped polysilicon layer 64 does not itself function as an emitter region, as in Fig. 4 device, but solely as an interface between the p region 60 and the metal layer 66. The functions of the polysilicon layer 64 are as afore described, i.e., as providing a good ohmic path for majority carriers, and providing fast recombination sites for minority carriers.

Preferably, the spacing between the p-n junction 62 (between the layers 32 and 60) and the polysilicon layer 64 should be large enough that the polysilicon layer 64 remains outside of the depletion region which spreads into the p region 60 from the p-n junction 62 when the device is in its reverse biased condition. Relatively high leakage currents would flow if this occurred.

The presence of the polysilicon layers 40 and 64 in the Figs. 4 and 6 devices, respectively, provides high speed recombination of minority carriers otherwise difficult to remove from a highly doped region (e.g., the region 12 in Fig. 1) contacted by an electrode through an intervening region of high conductivity (e.g., the region 14 in Fig. 1). The polysilicon layers 40 and 64 thus directly replace such intervening high conductivity regions but, instead of blocking the floe of minority carriers by an energy barrier provided by the p⁺ p junction 16 (Fig. 1 and 1A), function substantially as a mosaic layer 18 (Fig. 2 and 2A) for providing a good ohmic path for removal of minority charge carriers. However, whereas the mosaic layer 18 provides n⁺ regions 22 for the conduction of electrons (the minority carrier in the illustrative embodiments shown in Fig. 4 and 6 herein) to a contacting electrode 10, the grain boundary traps of the polysilicon layers serve as sites where the minority carriers are trapper or recombined. The results, in terms of removal of the minority carriers for providing high speed switching, are the same regardless of whether the minority carriers are removed by conduction to an electrode, as with a mosaic layer 18, or removed by annihilation by trapping and recombination by the polysilicon layers.

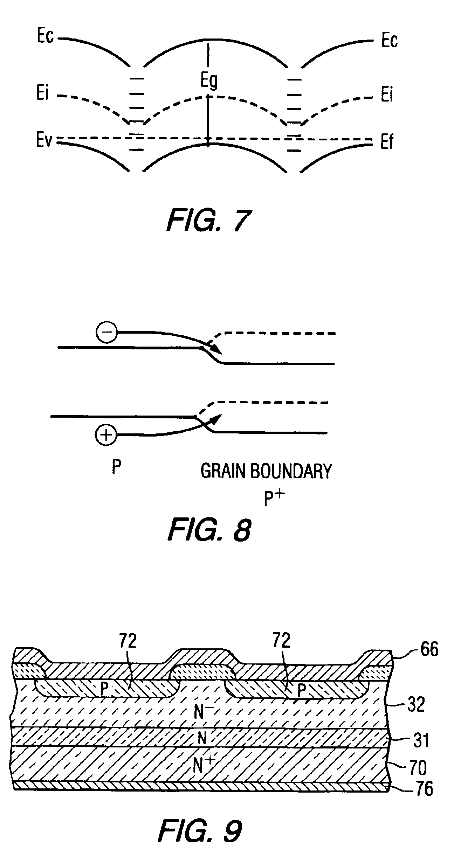

The function of the grain boundary traps is indicated in Fig. 7 which is an energy band diagram for p doped polysilicon, and in Fig. 8 which is a band structure diagram similar to the previously discussed diagrams shown in Figs. 1A and 2A.

With the removal of the minority charge carriers by trapping and annihilation, the lifetime of the minority carriers is reduced for effecting faster device switching. The minority carrier lifetime (t) in polysilicon can be estimated by the following known approximation: t= 1/υσN, where N is the effective trap density, u is the thermal velocity of the minority carriers, and o is the capture cross section for the minorities. For cubic grains, the number of recombination centers per unit volume is given by N=6n d where n is the concentration of recombination centers per unit area at a grain boundary and d is grain size. If we take n - 1.6x10¹³cm⁻², υ - 10⁷cm/s, σ - 2x10⁻¹⁶cm² (See A. K. Ghosh, C. Fishman and T. Fens, J. Applied Physics, 51 (1980) 446), we can find the lifetime to be - 0.5x10⁻⁵d. In other words, the lifetime is in proportion to the grain size. If we take the grain size as 1.0 µm, the lifetime is around 5x10⁻¹¹ seconds, in picosecond order of magnitude.

In general, the shorter the minority carrier lifetime, the faster is device turn-off. Actual turn-off speeds required depend upon the particular device being made for a particular application.

In known power devices, lifetimes of between 10⁻⁶ second and 10⁻⁹ second are generally obtained.

In effect, and in somewhat simplified terms, the present invention can be considered as a modification or prior art practice where, instead of having traps distributed through the entire semiconductor chip (as is the result of the known prior art processes for introducing trap sites), the trap sites are disposed only where required. By such means, desired fast switching times are achieved, while known problems associated with the uncontrolled, full chip distribution of the trap sites, e.g., higher forward voltage drop and sharp reverse recovery time, are avoided.

The fact that charge carrier traps are present at grain boundaries is well known. Grain boundaries are typically regions of high recombination due to large numbers of dangling bonds, vacancies and other defects arising from the disruption of the crystalline lattice. It is also known that these lattice imperfections can be reduced through annealing, i.e., hydrogen heat treatment, in which hydrogen becomes bonded to dangling bond sites for filling vacancies and reducing the recombination rates at these sites. Impurities such as oxygen, nitrogen, and/or doping species also tend to accumulate at grain boundaries. Such unintentional impurity accumulation may either increase or decrease the grain boundary recombination rate.

In the more common usage of polysilicon in semiconductor devices simply as electrical conductors, impurity accumulation, while to be avoided, is not critical. However, where desired and reproducible results depend upon the presence of preselected minimum concentrations of trap sites, cleanliness is especially important. This is particularly true with respect to removal of naturally and rapidly forming "native" oxides on exposed surfaces of the semiconductor workpiece.

The use of layers of doped polysilicon in semiconductor devices is, as mentioned, well known, and known deposition processes can be used to fabricate devices according to the present invention. One known deposition technique, for example, is by low temperature (<600° C) chemical vapor deposition (CVD). Prior to the CVD deposition, the workpiece (Fig. 3) is bathed in diluted HF to clean the exposed surfaces 34a of the n layer 32 of "native" oxide coating. Thereafter, care is taken to prevent reoxidation of the workpiece surface until at least after the polysilicon deposition. Dopant atoms, e.g., boron, can be provided as part of the deposition process, in which case a doped layer of polysilicon is deposited, or an undoped layer of polysilicon can be deposited and the, e.g., boron atoms, later added by ion implantation.

Alternately, the polysilicon layer 40 can be provided by known sputter deposition during which boron atoms are simultaneously deposited for uniformly doping the polysilicon p type. In preparation of such sputter deposition, native oxides on the surface 34a of the n layer 32 are removed by sputter etching. An advantage to this latter process is that the workpiece is not removed from the sputtering apparatus between the oxide cleaning and polysilicon deposition steps.

After deposition of the polysilicon layer, an annealing process (as previously discussed) is typically performed with hydrogen gas or forming gas (hydrogen and nitrogen) at temperatures of around 400°- 600°C. Such annealing process is used for controlling or modifying the grain size and trap density within the polysilicon layer. In general, the effectiveness of the grain boundary traps is reduced with annealing temperature.

In the inventive devices, metal electrodes are contacted with the polysilicon layers and, for good ohmic contacting, the polysilicon layers are preferably doped as high as possible, e.g., in excess of 10²⁰ atoms/cm³. While, in the illustrative devices, p doped polysilicon layers are shown, n doped polysilicon can be used in connection with n type charge injectors. Known dopants such as phosphorous can be used.

Different thickness layers of polysilicon can be used depending upon the device. In the Fig. 4 embodiment, for example, where the polysilicon layer is the device emitter, typical thickness can be in the range of 0.5 µm to 2 µm. In the Fig. 6 embodiment, thickness in the range of 0.2 µm to 2 µm can be used.

While the embodiment shown in Figs. 4 and 6 are merely by way of illustration, both embodiments show the polysilicon layers on "top" of a semiconductor chip. By "top" is meant a chip surface which is subdivided into a plurality of spaced apart areas, e.g., the area 60 in Fig. 6 which can be but one charge injecting region of many such regions connected, for example, in parallel in a power controlling switch, e.g., an IGBT. In Fig. 6, the "bottom" surface of the chip is contacted by a single layer 46 of metal which, in an IGBT or the like, serves as a common electrode for all the sub-devices connected together in parallel at the "top" of the chip.

The present invention can be practiced with a single polysilicon layer 70 (Fig. 9) at the "bottom" of the chip. (Note that, in devices according to Fig. 4 or 6 comprising plurality of sub-devices connected together in parallel at the chip "top" surface, a corresponding plurality of respective polysilicon layers 40 and 60 are also present.) The device shown in Fig. 9 can be, basically, identical to the device shown in Fig. 6 but with the polysilicon p⁺ layer 60 in Fig. 6 replaced with a layer 72 of p⁺ monocrystalline silicon formed, e.g., by standard ion implantation of dopants into a epitaxially grown layer on a monocrystalline substrate. The Fig. 6 n⁺ layer 30, of monocrystalline silicone, is replaced with the n⁺ layer 70 of polysilicon in the Fig. 9 device. In the Fig. 9 device, the upper region 72 is replicated numerous times at the top of the chip, as indicated, by the polysilicon layer 70 is continuous and serves as a common region to all the overlying, inparallel regions 72. A layer 76 of metal contacts the "underside" of the polysilicon layer 70.

In the Fig. 9 device, lifetime control of minority carriers, for faster device switching time, is obtained by the polysilicon layer 70 similarly as by the polysilicon layers 40 and 60 in the Figs. 4 and 6 devices, respectively.

A semiconductor switch is provided with fast turn-off characteristics by the mechanism of rapid recombination of minority carriers within a charge injecting region of the device. The region itself, or a portion of each of a plurality of parallelconnected such regions, comprises a body of highly doped polycrystalline silicon comprising tiny mono-crystalline grains of silicon joined at boundaries between the grains. The grain boundaries provide deep level energy traps for the capture and rapid annihilation, by recombination, of minority carriers within the polycrystalline body. An electrode is ohmically contacted with the one or each polycrystalline silicon body for efficient injection of majority carriers into the body.

## Claims

1. A fast turn-off semiconductor power controlling switch comprising a first region of monocrystalline silicon forming a p-n junction with a second region of silicon characterized in that a third region of highly doped polycrystalline silicon, said third region having a surface spaced from but directly overlying said p-n junction and an electrode directly overlying and ohmically connected to said surface of said third region for injection charge carriers therein and into said second and said first regions.

2. A switch as claimed in Claim 1 characterized in that said second region consists entirely of said third region with said p-n junction being formed between said first region of monocrystalline silicon and said third layer of polycrystalline silicon.

3. A switch as claimed in claim 2 characterized in that said second and third regions are of the same conductivity type, and said third region is separated from said p-n junction by said second region, and said third region has an electrical conductivity greater than that of said second region.

4. A switch as claimed in Claim 3 characterized by a preselected reverse voltage breakdown capability, the spacing of said third region from said p-n junction being such that, when the switch is being operated at its maximum rated reverse voltage, the third region is spaced from the depletion region within said second region starting from said p-n junction.

5. A switch as claimed in claim 4 characterized by the body of monocrystalline silicon including contiguous first and second regions forming the p-n junction therebetween, a third region of polycrystalline silicon contiguous with said first region, said first and third regions being of the same conductivity type, with the metal electrode forming an ohmic contact with a surface of said third region directly overlying said p-n junction for injecting charge carriers into said third region and thence into said first region, and in which said second region has a higher conductivity than said first region.

6. A switch as claimed in to Claim 1 characterized in that said first region comprises one of a plurality of identical first regions spaced apart along a first surface of a body of monocrystalline silicon in which said first regions are disposed, and said third region comprises a continuous layer contiguous with a second surface of said body opposite to said first surface, said layer overlying all of said first regions.
